# EUROPÄISCHE PATENTANMELDUNG

(11) **EP 0 777 327 A1**
(43) Veröffentlichungstag der Anmeldung: **04.06.1997**
(21) Anmeldenummer: 95118871.3
(22) Anmeldetag: 30.11.1995
(51) Int. Cl.: H03K 17/968

(54) **Drucktastenschalter für Haushaltsgeräte**

(71) Anmelder: Haschkamp, Joachim, Dipl.-Ing., D-96364 Marktrodach (DE); Haschkamp, Wolfgang, Dipl.-Kfm., D-96364 Marktrodach (DE)
(72) Erfinder: Imer, Klaus, D-96317 Kronach (DE)
(74) Vertreter: Koch, Günther, Dipl.-Ing.

(57) **Zusammenfassung**

Ein Drucktastenschalter für Haushaltsgeräte ist als optischer Schalter mit Lichtsender und Lichtempfänger ausgebildet, wodurch galvanische Schaltkontakte vermieden sind. Der Lichtsender hat vorzugsweise eine weitere Funktion, indem er zur Beleuchtung eines Anzeigefeldes herangezogen wird, das im beleuchteten Zustand die Einschaltstellung der betreffenden Taste kennzeichnet. Zwischen Sender und Empfänger bzw. zwischen Sender und Anzeigefeld, das vorzugsweise im Tastenkopf als Fenster ausgebildet ist, können Lichtleitstäbe bzw. Lichtleitprismen Verwendung finden, die durch Totalreflexion die erforderliche Strahlablenkung bewirken.

## Beschreibung

Die Erfindung bezieht sich auf einen Drucktastenschalter für Haushaltsgeräte. Derartige Drucktastenschalter werden im allgemeinen als Paketschalter mit mehreren nebeneinanderliegenden Tastenschiebern in Haushaltsgeräten, beispielsweise Waschmaschinen, Wäschetrocknern, Geschirrspülern o. dgl. als Programmwahlschalter eingesetzt. Hierbei ist es üblich, die Programme nicht direkt über Netzspannungsschalter zu schalten, sondern es wird eine Elektronik vorgesehen, die zum Teil unter Anwendung eines Mikroprozessors die gewünschten Programme schaltet. Dabei fließen über die benutzten mechanischen Tastkontakte oder Schleifkontakte bei Spannungen zwischen 5 und 12 Volt geringe Ströme, die im Mikroamperebereich oder im Milliamperebereich liegen. Da bei den hier verwendeten niedrigen Spannungen und den geringen, die Schaltkontakte durchfließenden Strömen bereits geringfügige Verunreinigungen oder Oxydationen die Kontaktgabe beeinträchtigen können, müssen besondere Vorkehrungen getroffen werden, um eine zuverlässige Kontaktgabe ohne wesentlichen Übergangswiderstand zu gewährleisten. Aus diesem Grunde werden in der Regel Goldkontakte verwendet, die jedoch auch bei der geringsten Verschmutzung versagen können, was nur durch eine aufwendige Kapselung der Kontakte vermieden werden kann.

Der Erfindung liegt daher die Aufgabe zugrunde, einen kostengünstig herstellbaren Drucktastenschalter zu schaffen, der eine Schaltung sowohl im Niederspannungsbereich als auch im Netzspannungsbereich ermöglicht, und bei dem durch Fortfall mechanischer Kontakte eine zuverlässige und dauerhafte Kontaktierung gewährleistet ist.

Gelöst wird die gestellte Aufgabe durch die im Kennzeichnungsteil des Patentanspruchs 1 angegebenen Merkmale. Der Erfindung liegt die Erkenntnis zugrunde, daß eine an sich bekannte Lichtschranke bei einem Drucktastenschalter vorteilhaft eingesetzt werden kann, indem durch Verschiebung des Tastenschiebers der Strahlengang zwischen Sender und Empfänger unterbrochen werden kann. Vorzugsweise ist dabei die Anordnung derart getroffen, daß mit dem Netzschalter sämtliche Lichtsender, die vorzugsweise als Leuchtdioden ausgebildet sind, in den Einschaltzustand überführt werden, wobei im Ausschaltzustand des Drucktastenschalters der Strahlengang zwischen Lichtsender und -empfänger freiliegt, so daß eine Funktionskontrolle möglich wird. Beim Einschalten, d.h. Niederdrücken der Taste des Tastenschalters, wird der Strahlengang unterbrochen, wodurch über die Elektronik oder auch direkt über ein Optotriac die Schaltung vorgenommen wird.

Es ist zwar durch die EP-A-0 570 870 bereits ein für Haushaltsgeräte bestimmter Wahlschalter bekanntgeworden, bei dem über Optoelemente und reflektierende und nicht reflektierende Bereiche eine Kodierung vorgenommen wird, wobei das Kodiermuster in einem Mikroprozessor in entsprechende Schaltbefehle umgeformt wird. Bei dem bekannten Schalter handelt es sich jedoch um einen Drehschalter, bei dem die Lichtreflexions- bzw. Lichtleitbereiche auf konzentrischen Ringen angeordnet sind. Eine solche Ausbildung ist bei einem Drucktastenschalter der angegebenen Gattung nicht möglich.

Bei derartigen Drucktastenschaltern, die gewöhnlich als Paketschalter mit mehreren nebeneinanderliegenden Tasten ausgebildet sind, ist es bekannt, zur Schaltstellungsanzeige Beleuchtungselemente vorzusehen, die im Feld der betreffenden Taste aufleuchten, wenn die Taste gedrückt ist. Diese Anzeigelämpchen waren bisher als Glimmlampen ausgebildet und wurden über entsprechende mechanische Kontakte des Tastenschiebers geschaltet.

Der Erfindung liegt weiter die Aufgabe zugrunde, eine Leuchtanzeige für die Schaltstellung gedrückter Tastenschieber zu schaffen, die ebenfalls ohne mechanische Kontakte und ohne eine zusätzliche Beleuchtungsquelle auskommt. Gelöst wird diese Aufgabe durch die im Anspruch 2 angegebenen Merkmale in Verbindung mit einem Drucktastenschalter gemäß Anspruch 1. Danach wird die für den Optoschalter vorgesehene Lichtquelle, vorzugsweise die Leuchtdiode, zugleich als Anzeigelampe benutzt, wobei diese Leuchtdiode das Anzeigefeld im gedrückten Zustand des Schiebers entweder direkt oder vorzugsweise über einen Lichtleitstab beleuchtet, der in gedrückter Schalterstellung von der Leuchtdiode beleuchtet wird. In Kombination mit diesem Lichtleitstab kann ein totalreflektierendes Prisma vorgesehen sein, welches einen Lichtpfad zwischen Lichtsender und -empfänger bildet, sobald das Prisma bei nicht eingedrücktem Schalter vor den beiden Elementen des Optoschalters zu liegen kommt.

Vorzugsweise sind Leuchtdiode und Photodetektor benachbart zueinander angeordnet, wobei der Lichtpfad auch durch eine Blende gesperrt werden kann, die mit dem Tastenschieber verbunden ist. Diese Ausführungsform kommt insbesondere dann in Betracht, wenn bei einer vereinfachten Ausführungsform keine beleuchtete Schaltstellungsanzeige gewünscht wird.

Das Anzeigefenster für die Schaltstellungsanzeige ist vorzugsweise im Tastenkopf als Fenster ausgebildet, hinter dem ein Lichtleitstab endet. Falls eine beleuchtete Anzeige nicht erwünscht ist, kann bei gleicher Gesamtausbildung einfach ein Tastenkopf Verwendung finden, der kein Fenster aufweist.

Gemäß einem bevorzugten Ausführungsbeispiel ist das Schalterpaket auf einer Leiterplatte aufgesetzt, welche die nach Leuchtdiode und Photodetektor führenden Leitungen aufgedruckt enthält, während die Verbindung mit dem Mikroprozessor oder mit der Schaltelektronik über flexible elektrische Leitungen erfolgen kann. Es soll für die Erfindung jedoch auch vorbehalten bleiben, flexible Lichtleiter einzusetzen, die das Licht von einem entfernt liegenden Lichtsender heran und nach verschiedenen Photodetektoren abführen. Auch bei dieser Ausführungsform ist eine Beleuchtung eines Anzeigefeldes durch den Lichtsender möglich.

Nachstehend werden Ausführungsbeispiele der Erfindung anhand der Zeichnung beschrieben. In der Zeichnung zeigen:
Fig. 1 ist eine Seitenansicht eines Schalterpaketes mit mehreren in Reihe nebeneinander angeordneten Drucktastenschaltern;
Fig. 2 ist eine Draufsicht des Schalterpaketes gemäß Fig. 1;
Fig. 3 zeigt in größerem Maßstab einen Halbschnitt eines der Drucktastenschalter des Paketes nach Fig. 1 und 2 mit Leuchtanzeige in der Ausschaltstellung;
Fig. 4 eine der Fig. 3 entsprechende Schnittansicht des Drucktastenschalters in eingeschalteter Stellung;
Fig. 5 eine der Fig. 4 entsprechende Ansicht des gleichen Tastenschalters, jedoch ohne Leuchtanzeige;
Fig. 6 einen Teilschnitt einer abgewandelten Ausführungsform eines Drucktastenschalters ohne Leuchtanzeige in ausgeschalteter Stellung;
Fig. 7 eine der Fig. 6 entsprechende Ansicht in Einschaltstellung.

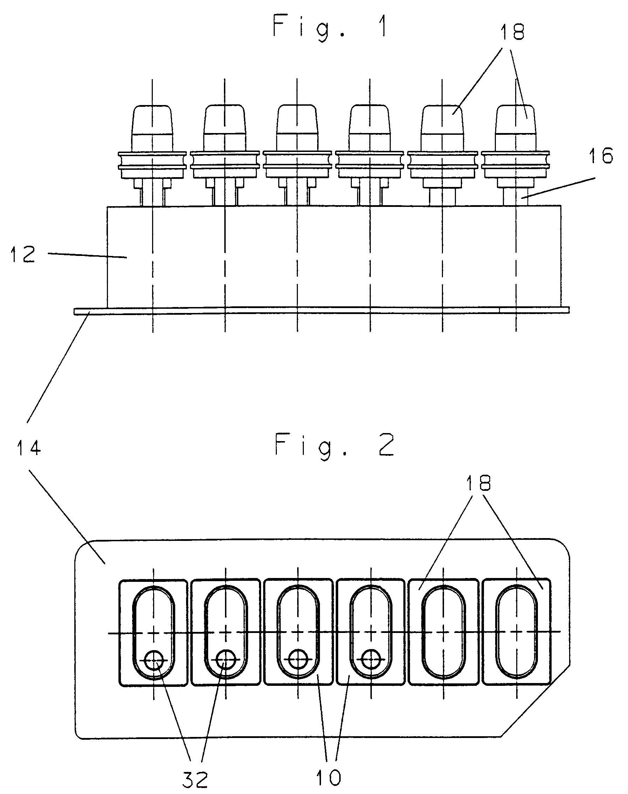

Das Schalterpaket gemäß Fig. 1 und 2 weist mehrere nebeneinander liegende Drucktastenschalter 10 auf, die in einem Gehäuse 12 nebeneinander in Reihe angeordnet sind. Unter dem Gehäuse 12 ist eine Leiterplatte ersichtlich. Die Anschlüsse sind der Übersichtlichkeit wegen nicht dargestellt. Bei dem dargestellten Ausführungsbeispiel sind die ersten vier Drucktastenschalter (von links nach rechts betrachtet) mit Leuchtanzeige versehen, während die beiden letzten Schalter keine Leuchtanzeige besitzen. Die mit Leuchtanzeige versehenen vier Drucktastenschalter können als Programmschalter, beispielsweise für eine Waschmachine, ausgebildet sein, während der fünfte Drucktastenschalter als Ein-Aus-Schalter ausgebildet sein kann und der letzte Drucktastenschalter als mechanischer Türöffnungsschalter ausgebildet ist, der beim Niederdrücken über eine an sich bekannte Mechanik die Progammschalter in die Ausschaltstellung überführt.

Jeder Drucktastenschalter 10 weist einen im Gehäuse 12 verschiebbar gelagerten Tastenschieber 16 auf, der einen zur Betätigung dienenden Tastenkopf 18 aufweist. Parallel zum Tastenschieber 16 ist im Tastenkopf ein prismatischer Lichtleitstab 20 angeordnet, der mit dem Schieber 16 in das Gehäuse 12 eintaucht.

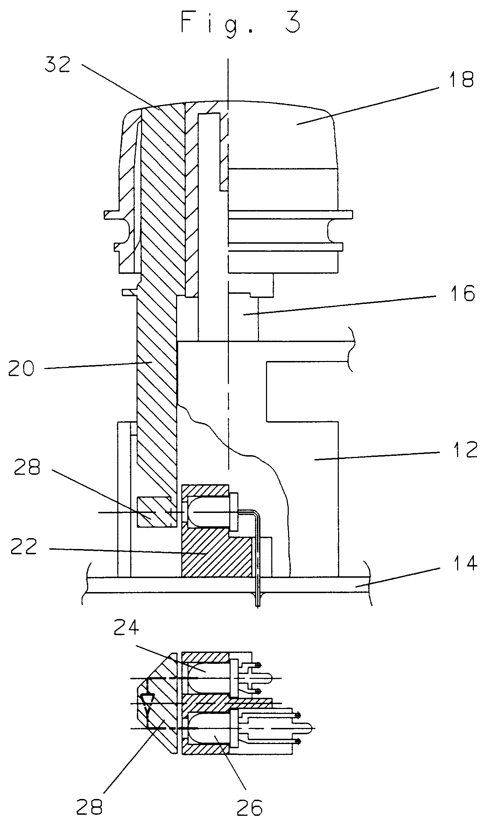

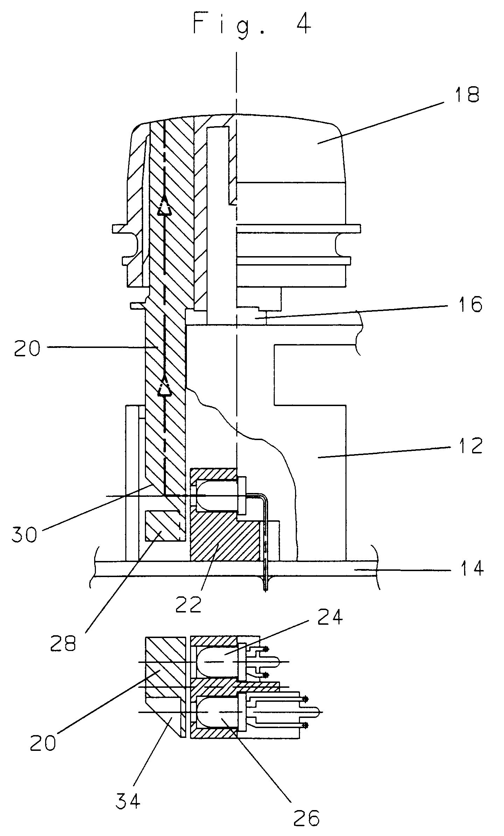

Im unteren Teil des Gehäuses ist auf der Leiterplatte 14 ein Aufnahmeblock 22 aufgesetzt, der nebeneinander eine Leuchtdiode 24 und einen Photodetektor 26, beispielsweise einen Phototransistor, trägt. Die vordere Stirnfläche von Leuchtdiode und Photodetektor liegt je vor einer Öffnung des Aufnahmeblocks. Der Aufnahmeblock 22 selbst ist lichtundurchlässig und derart ausgebildet, daß der Photodetektor 6 nicht direkt vom Licht der Leuchtdiode getroffen werden kann. Diese Ausbildung ist aus der Querschnittsdarstellung im unteren Teil von Fig. 3 und 4 deutlich ersichtlich.

Das Licht der Leuchtdiode 24 erreicht den Photodetektor 26 nur dann, wenn das Licht auf den Photodetektor eingespiegelt wird. Gemäß dem dargestellten Ausführungsbeispiel ist zu diesem Zweck am unteren Ende des Lichtleitstabes 20 ein im Querschnitt trapezförmiges Prisma 28 angeordnet, das in der Aus-Stellung gemäß Fig. 3 durch zweifache Totalreflexion das Licht der Leuchtdiode 24 auf den Photodetektor 26 auftreffen läßt (Fig. 3). In dieser Stellung wird der Lichtleitstab 20 von der Leuchtdiode im wesentlichen nicht getroffen.

Wird der Tastenkopf 18 niedergedrückt und aus der Stellung gemäß Fig. 3 in die Stellung gemäß Fig. 4 verschoben, dann legt sich der untere Endabschnitt des Lichtleitstabes vor die Leuchtdiode. Dieser untere Prismenabschnitt 30 weist eine unter 45° verlaufende Schrägfläche auf, die, wie aus Fig. 4 ersichtlich, eine Totalreflexion bewirkt und das Licht der Leuchtdiode im Lichtleitstab 20 in Pfeilrichtung nach oben reflektiert. Das obere Ende des Lichtleitstabes liegt in einem Fenster 32 der Betätigungstaste und fluchtet mit der oberen Oberfläche dieser Taste. Auf diese Weise wird der eingedrückte Zustand der Betätigungstaste durch Aufleuchten am Fenster 32 erkennbar. Die Anordnung ist dabei derart getroffen, daß in gedrückter Stellung ein Lichtübertritt von der Leuchtdiode nach dem Photodetektor verhindert ist, um definierte Schaltstellungen zu gewährleisten. Zu diesem Zweck ist das untere Ende des Lichtleitstabes, wie aus Fig 4 unten ersichtlich, mit einem Ausschnitt 34 versehen, der einen Lichtübertritt verhindert.

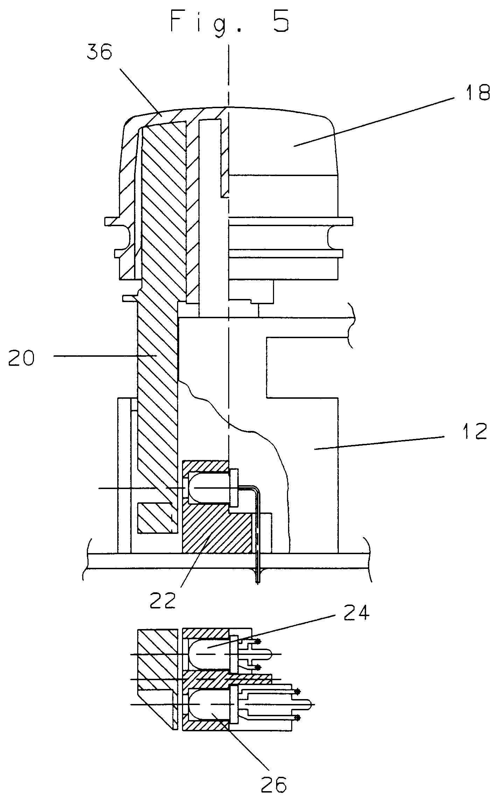

Falls eine Leuchtanzeige nicht erwünscht ist, findet gemäß Fig. 5 ein Tastenkopf 18 Verwendung, bei dem das Fenster 32 fehlt und das obere Ende des Lichtleitstabes 20 von der Frontseite 36 des Tastenkopfes abgedeckt ist.

Der Drucktastenschalter gemäß Fig. 3 bis 5 kann demgemäß sowohl mit als auch ohne Leuchtanzeige Verwendung finden, einfach indem unterschiedliche Tastenköpfe 18 aufgesetzt werden.

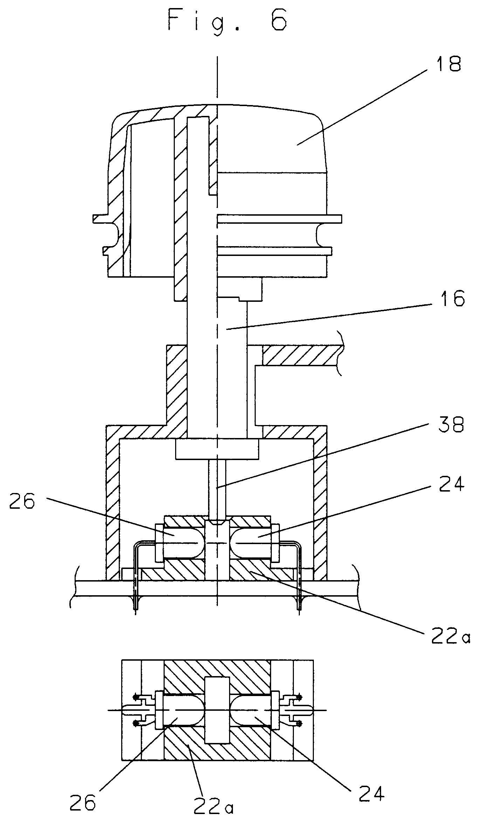

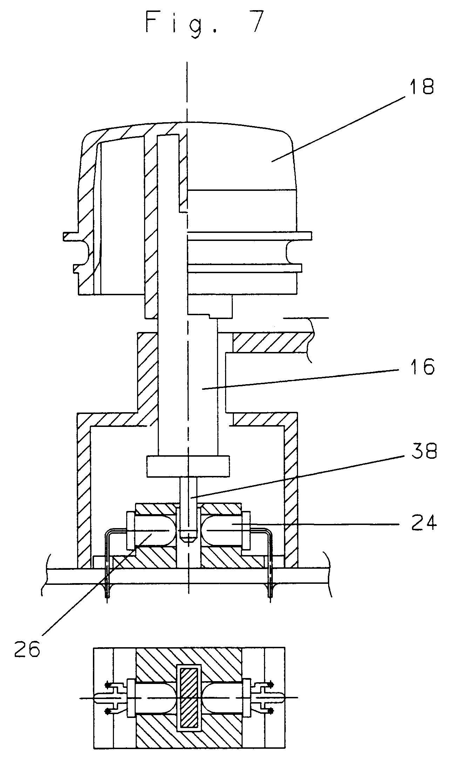

Die Fig. 6 und 7 zeigen eine Ausführungsform, bei der keine Leuchtanzeige vorhanden ist. Hier sind Leuchtdiode 24 und Photodetektor 26 stirnseitig gegenüberliegend in einem Aufnahmeblock 22a angeordnet. Der Lichtleitstab 20 fehlt bei dieser Ausführungsform. Der Tastenschieber 16 trägt an seinem unteren Ende eine Blende 38, die in der gedrückten Einschaltstellung (Fig. 6) zwischen Leuchtdiode 24 und Phototdektor 26 liegt und das Licht der Leuchtdiode vom Photodetektor abschirmt. In der in Fig. 7 dargestellten Ausschaltstellung ist der Tastenschieber und mit ihm die Blende 38 angehoben, und die Blende 38 gibt die Lichtübertragungsstrecke zwischen Leuchtdiode und Photodetektor frei.

Gemäß allen dargestellten Ausführungsbeispielen wird in der Einschaltstellung die Lichtübertragung zwischen Leuchtdiode und Photodetektor abgesperrt, während in der Ausschaltstellung das Licht der Leuchtdiode den Photodetektor beleuchten kann. Diese Ausführungsform ist zu bevorzugen, weil hierdurch eine funktionelle Kontrolle möglich wird. Es soll für die Erfindung jedoch auch vorbehalten bleiben, die umgekehrte Anordnung zu treffen, d.h. eine freie Lichtübertragung in Einschaltstellung und eine Unterbrechung in Ausschaltstellung.

Die für die Schaltung erforderliche Elektronik ist nicht im einzelnen dargestellt, da ihre Ausgestaltung im einzelnen dem Fachmann geläufig ist.

In jedem Falle bewirkt über die Elektronik der Schaltzustand des Photodetektors eine Ein- und Abschaltung der Programme, wobei für diese Schaltung keinerlei mechanische Kontakte erforderlich sind, bei denen die galvanische Verbindung durch Verschmutzung unterbrochen werden könnte.

Es soll jedoch für die Erfindung vorbehalten bleiben, zusätzlich an den Drucktastenschaltern mechanische Kontakte anzuordnen, die beispielsweise als Netzschalter Verwendung finden können.

### Bezugszeichenliste

- 10: Drucktastenschalter
- 12: Gehäuse
- 14: Leiterplatte
- 16: Tastenschieber
- 18: Tastenkopf
- 20: Lichtleitstab
- 22,22a: Aufnahmeblock
- 24: Leuchtdiode
- 26: Photodetektor (Phototransistor)
- 28: Prisma
- 30: Priasmenabschnitt
- 32: Fenster
- 34: Ausschnitt
- 36: Frontseite
- 38: Blende

## Patentansprüche

1. Drucktastenschalter für Haushaltsgeräte
dadurch gekennzeichnet, daß er als optischer Schalter mit Lichtsender (24) und Lichtempfänger (26) ausgebildet ist, bei dem in einer ersten Schaltstellung die Lichtübertragung zwischen Sender und Empfänger freigegeben in einer zweiten Schaltstellung unterbrochen ist.

2. Drucktastenschalter nach Anspruch 1,
dadurch gekennzeichnet, daß in einer der beiden Schaltstellungen der Lichtsender (24) ein Anzeigefeld (32) beleuchtet.

3. Drucktastenschalter nach Anspruch 2,
dadurch gekennzeichnet, daß als Anzeigefeld ein Fenster (32) im Tastenkopf (18) vorgesehen ist.

4. Drucktastenschalter nach Anspruch 1,
dadurch gekennzeichnet, daß die erste Stellung die Ausschaltstellung ist, in der das Licht des Lichtsenders auf den Empfänger trifft.

5. Drucktastenschalter nach den Ansprüchen 1 bis 4,
dadurch gekennzeichnet, daß in der zweiten Stellung (Einschaltstellung) der Lichtsender (24) das Anzeigefeld (32) beleuchtet.

6. Drucktastenschalter nach einem der Ansprüche 1 - 5
dadurch gekennzeichnet, daß zwischen Lichtsender (24) und Anzeigefenster (32) ein im wesentlichen parallel zur Tastenachse verlaufender Lichtleiter (20) am Tastenschieber (16) angeordnet ist, dessen Eingangsende in der zweiten Schaltstellung (Einschaltstellung) vom Lichtsender (24) beaufschlagt ist.

7. Drucktastenschalter nach einem der Ansprüche 1 - 6,
dadurch gekennzeichnet, daß der vorzugsweise als Leuchtdiode (24) ausgebildete Lichtsender parallel zu dem vorzugsweise als Phototransistor (26) ausgebildeten Empfänger in einem opaken Aufnahmeblock (22) angeordnet ist und daß ein mit dem Tastenschieber (16), vorzugsweise mit dem Lichtleiter (20) verbundenes Prisma (28) in Ausschaltstellung das Licht des Senders auf den Empfänger reflektiert.

8. Drucktastenschalter nach Anspruch 1,
dadurch gekennzeichnet, daß der Tastenschieber (16) eine Blende (38) trägt, die in Einschaltstellung im Lichtpfad zwischen Sender und Empfänger liegt.

9. Drucktastenschalter nach einem der Ansprüche 1 - 8,
dadurch gekennzeichnet, daß über den Optoschalter eine Programmelektronik und/oder ein oder mehrere Netzschalter z. B. über ein Optotriac steuerbar sind.

10. Drucktastenschalter nach einem der vorhergehenden Ansprüche,
dadurch gekennzeichnet, daß der Tastenschieber (16) außer dem Optoschalter noch galvanische Kontakte betätigt.
